(19)

Europäisches
Patentamt

European
Patent Office

Office européen
des brevets

(11)     **EP 4 471 875 B1**

(12)                    **EUROPEAN PATENT SPECIFICATION**

(45) Date of publication and mention
     of the grant of the patent:
     **18.03.2026   Bulletin 2026/12**

(21) Application number: **23195952.9**

(22) Date of filing: **07.09.2023**

(51) International Patent Classification (IPC):
     **H10F 19/90** *(2025.01)*        **H10F 77/20** *(2025.01)*

(52) Cooperative Patent Classification (CPC):
     **H10F 19/902; H10F 77/215;** Y02E 10/50

(54) **PHOTOVOLTAIC MODULE AND METHOD FOR MANUFACTURING PHOTOVOLTAIC MODULE**

FOTOVOLTAISCHES MODUL UND VERFAHREN ZUR HERSTELLUNG EINES
FOTOVOLTAISCHEN MODULS

MODULE PHOTOVOLTAÏQUE ET PROCÉDÉ DE FABRICATION DE MODULE PHOTOVOLTAÏQUE

(84) Designated Contracting States:
     **AL AT BE BG CH CY CZ DE DK EE ES FI FR GB
     GR HR HU IE IS IT LI LT LU LV MC ME MK MT NL
     NO PL PT RO RS SE SI SK SM TR**

(30) Priority:  **02.06.2023   CN 202310651015**

(43) Date of publication of application:
     **04.12.2024   Bulletin 2024/49**

(73) Proprietors:
     • **JINKO SOLAR CO., LTD.**
       **Shangrao, Jiangxi 334100 (CN)**
     • **ZHEJIANG JINKO SOLAR CO., LTD.**
       **Haining, Zhejiang 314416 (CN)**

(72) Inventors:
     • TAO, Wusong
       **SHANGRAO, JIANGXI, 334100 (CN)**
     • FENG, Jun
       **SHANGRAO, JIANGXI, 334100 (CN)**
     • LUO, Heng
       **SHANGRAO, JIANGXI, 334100 (CN)**

(74) Representative: **Studio Torta S.p.A.**
     **Via Viotti, 9
     10121 Torino (IT)**

(56) References cited:
     CN-A- 108 649 090    CN-A- 110 611 007
     CN-A- 114 823 961    US-A1- 2023 066 369

# Description

## TECHNICAL FIELD

The present disclosure relates to the technical field of photovoltaic modules and, in particular, to a photovoltaic module and a method for manufacturing photovoltaic module.

## BACKGROUND

A photovoltaic module is a device that utilizes clean energy for power generation, which has great application prospect in the market.

The photovoltaic module generally includes a pad and a solder strip electrically connected to each other and configured to conduct a current.

However, in the related art, the connection between the pad and the solder strip of conventional photovoltaic module has poor reliability. Especially there are many cases of dummy bonding between the pad and the solder strip, resulting in poor operational reliability of the photovoltaic module. Prior art document CN110611007A is considered as relevant technology which discloses a solar cell. The solar cell comprises conductive pads, bus bars, wires and bus sub-wires, the conductive pads are arranged in a first direction. The bus bars are respectively located between the conductive pads and extend along a first direction.

## SUMMARY

The present disclosure provides a photovoltaic module and a method for manufacturing photovoltaic module, which reduce the possibility of dummy bonding between the pad and the solder strip, thereby improving operational reliability of the photovoltaic module.

In a first aspect of the present disclosure, a photovoltaic module according to claim 1 is provided. The photovoltaic module includes at least one solar cell, a solder strip, a pad, fasteners, adhesive films, a light-transmitting member, and a back sheet. The pad is arranged on a surface of the solar cell and including a first part, a second part, and a third part. The first part is connected to the third part through the second part, and along a length direction of the solder strip, a width of the second part is less than a width of the first part and a width of the third part. The fasteners are arranged on a side of the first part facing away from the solar cell and a side of the third part facing away from the solar cell. The solder strip is provided between the fastener in the first part and the fastener in the third part, and the solder strip is connected to the pad through the fastener to form a solar cell string. The adhesive films are arranged on two sides of the solar cell string along a thickness direction of the solar cell string. The light-transmitting member is arranged on a side of one of the adhesive films facing away from the solar cell string. The back sheet is arranged on a side of the other one of the adhesive films facing away from the solar cell string.

In one or more embodiments, a sidewall of the solder strip abuts against a side of the second part facing away from the solar cell.

In accordance with the invention, the fastener has a set height H1, and the solder strip has a set height H2, where

$$0 < H1 \le 0.5 * H2.$$

In one or more embodiments, the fastener has a set width W1 along the length direction of the solder strip, where $0.10 \text{ mm} \le W1 \le 0.20 \text{ mm}$.

In one or more embodiments, a projection of the fastener projected along the length direction of the solder strip is in a shape of a triangle, a fan, or a slope.

In one or more embodiments, a cross section of the solder strip is in a shape of a circle, and at least part of a sidewall of the solder strip facing the pad is connected to the pad through the fastener; or a cross section of the solder strip is in a shape of a triangle, a rectangle, or an ellipse.

In one or more embodiments, the pad has a shape of a dumbbell, a gourd, an hourglass, or a symbol ∞.

In one or more embodiments, at least part of the first part perpendicular to a sidewall of the solar cell and/or at least part of the third part perpendicular to the sidewall of the solar cell is an arc surface.

In one or more embodiments, the photovoltaic module further includes a finger and a busbar arranged on the solar cell, the first part and the third part are respectively connected to the finger, and the finger is arranged along a direction intersecting with the length direction of the solder strip; and the busbar is connected to the second part, and the busbar is arranged along the length direction of the solder strip.

In one or more embodiments, the fastener is made of tin, solder paste, conductive silver paste, or conductive adhesive.

In a second aspect of the present disclosure, a method for manufacturing a photovoltaic module according to claim 13 is provided. The method includes: step S1: placing the fasteners respectively on the first part and the third part of the pad arranged on the solar cell; step S2: connecting, through the fasteners, the solder strip with the pad arranged on the solar cell; step S3: connecting the solder strip connected to a front surface of the solar cell to a back surface of another solar cell to form a solar cell string; step S4: stacking a back sheet, an adhesive film, the solar cell string, and a light-transmitting member to form a stacking member; step S5: laminating the stacking member to form a laminated structure; and step S6: mounting a frame and a junction box on the laminated structure to form the photovoltaic module.

In one or more embodiments, the connecting, through the fasteners, the solder strip with the pad arranged on the solar cell includes: abutting the solder strip against a side of the second part facing away from the solar cell, and placing the solder strip between the fastener on a side of the first part facing away from the solar cell and the fastener on a side of the third part facing away from the solar cell.

It should be understood that the foregoing general description and the following detailed description are exemplary only and are not intended to limit the present disclosure.

## BRIEF DESCRIPTION OF DRAWINGS

FIG. 1 is a schematic structural diagram of a photovoltaic module according to one or more embodiments of the present disclosure;

FIG. 2 is a partial enlarged view of Part A in FIG. 1;

FIG. 3 is a schematic diagram of a connection structure of a solar cell, a pad, fasteners, and a solder strip in a perspective view;

FIG. 4 is a schematic diagram of a connection structure of a solar cell, a pad, a finger, and a busbar in a top view;

FIG. 5 is a schematic structural diagram of a photovoltaic module according to one or more embodiments of the present disclosure;

FIG. 6 is a schematic diagram of a connection structure of a solar cell, a pad, and fasteners in a perspective view; and

FIG. 7 is a flowchart of a method for manufacturing photovoltaic module according to one or more embodiments of the present disclosure.

The accompanying drawings herein are incorporated in and constitute a part of this specification, which illustrate embodiments consistent with the present disclosure and, together with the specification, serve to explain the principles of the present disclosure.

## DESCRIPTION OF EMBODIMENTS

In order to better understand the technical solutions of the present disclosure, embodiments of the present disclosure are described in detail below with reference to the accompanying drawings.

It is to be made clear that the described embodiments are only some rather than all of the embodiments of the present disclosure.

The terms used in embodiments of the present disclosure are intended only to describe particular embodiments and are not intended to limit the present disclosure. As used in the embodiments of the present disclosure and the appended claims, the singular forms of "a/an", "the", and "said" are intended to include plural forms, unless otherwise clearly specified by the context.

It is to be understood that the term "and/or" used herein is merely an association relationship describing associated objects, indicating that three relationships may exist. For example, A and/or B indicates that there are three cases of A alone, A and B together, and B alone. In addition, the character "/" herein generally means that the associated objects are in an "or" relationship.

It is to be noted that the location terms such as "above", "below", "left", and "right" described in the embodiments of the present disclosure are described with reference to the angles shown in the accompanying drawings, and should not be construed as limitations on the embodiments of the present disclosure. In addition, in the context, it is to be further understood that, when one element is referred to as being connected "above" or "below" another element, the one element may be directly connected "above" or "below" another element, or connected "above" or "below" another element via an intermediate element.

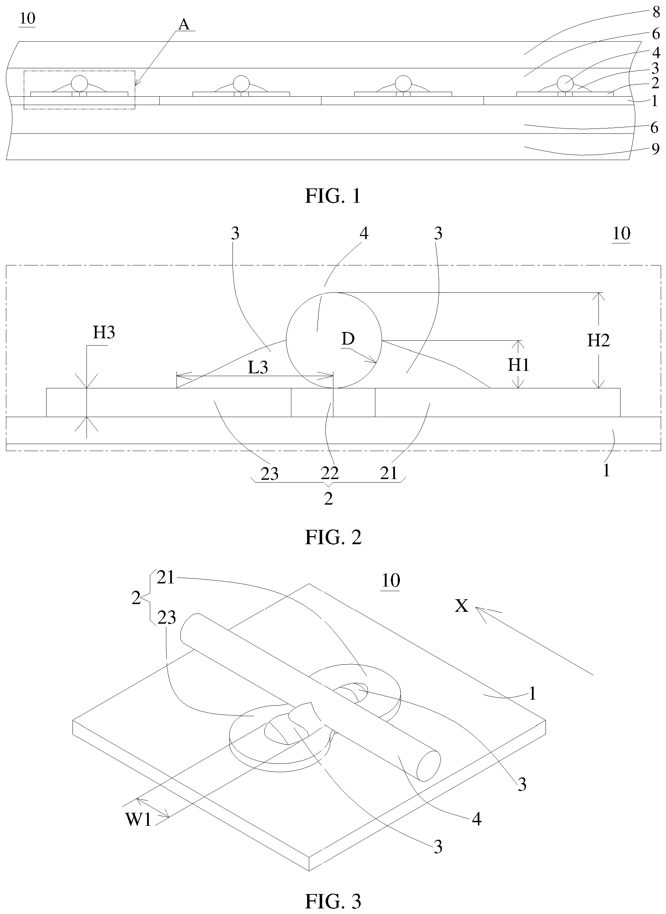

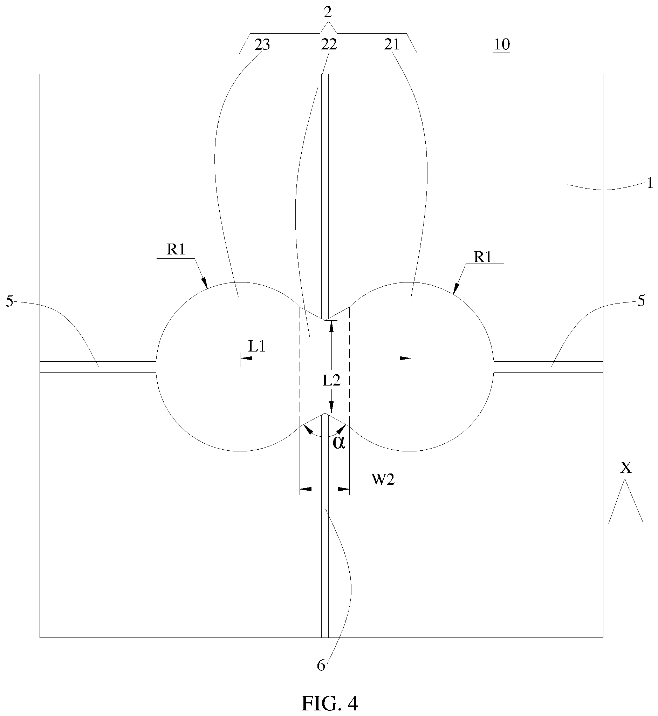

In a first aspect, some embodiments of the present disclosure provide a photovoltaic module. Referring to FIG. 1, the photovoltaic module 10 includes a solar cell 1, a pad 2, fasteners 3, and a solder strip 4. Referring to FIG. 2 to FIG. 3, the pad 2 is arranged on a surface of the solar cell 1. Referring to FIG. 4, the pad 2 has a first part 21, a second part 22, and a third part 23, and the first part 21 is connected to the third part 23 through the second part 22. A dotted line in FIG. 4 represents a structural boundary. Referring to FIG. 3 to FIG. 4, along a length direction X of the solder strip 4, a width of the second part 22 is less than a width of the first part 21 and a width of the third part 23. Referring to FIG. 2 to FIG. 3, the fasteners 3 are respectively arranged on a side of the first part 21 facing away from the solar cell 1 and a side of the third part 23 facing away from the solar cell 1. The solder strip 4 is provided between the fastener 3 in the first part 21 and the fastener 3 in the third part 23, and the solder strip 4 is connected to the pad 2 through the fastener 3 to form a solar cell string.

In some embodiments, referring to FIG. 1 to FIG. 4, the solar cell 1 uses a semiconductor photoelectric effect to generate electric energy after receiving solar energy, the electric energy of the solar cell 1 may be conducted sequentially through the pad 2 electrically connected to the solar cell 1, the fastener 3 electrically connected to the pad 2, and the solder strip 4 electrically connected to the fastener 3. An electrical component (not shown in the figures) electrically connected to the solder strip 4 in the photovoltaic module 10 may conduct the electric energy to electrical equipment outside the photovoltaic module 10. The first part 21 of the pad 2 is connected to the solder strip 4 through one fastener 3, and the third part 23 of the pad 2 is connected to the solder strip 4 through the other fastener 3. Compared with the photovoltaic module in the related art, in the photovoltaic module 10 according to the present disclosure, there are more fixed connection positions between the solder strip 4 and the pad 2, and the connection between the solder strip 4 and the pad 2 has higher reliability. As a result, the photovoltaic module 10 has higher operational reliability and a longer service life. In addition, the first part 21 of the pad 2 is connected to the third part 23 through the second part 22, that is, the first part 21 and the third part 23 are arranged apart from each other, and the solder strip 4 is located between the first part 21 and the third part 23. Therefore, it is thus possible that two sides of the sidewall of the solder strip 4 along a direction perpendicular to an length direction X of the solder strip 4 are respectively connected to the first part 21 and the third part 23 through the fasteners 3, and a position where the solder strip 4 is fixedly connected to the first part 21 and a position where the solder strip 4 is fixedly connected to the third part 23 are symmetrical with respect to the length direction X of the solder strip 4, which further improves stability of the connection structure between the solder strip 4 and the pad 2. Moreover, along the length direction X of the solder strip 4, the width of the second part 22 is less than the width of the first part 21 and the width of the third part 23, which can save materials for manufacturing the pad 2. In this way, more fasteners 3 can be placed on the first part 21 and the third part 23 with larger widths, thereby improving reliability of the connection between the pad 2 and the solder strip 4.

The solder strip 4 connected, through the fastener 3, to the pad 2 arranged on one solar cell 1 may be connected, through another fastener 3, to another pad 2 arranged on another solar cell 1, to form a solar cell string. The number of solar cells 1 connected to the solar cell string may be set accordingly according to the requirements of the user on desired power to be generated, and the number of solar cell strings included in the photovoltaic module 10 may be set accordingly according to the requirements of the user on desired power to be generated.

In addition, referring to FIG. 1, the photovoltaic module 10 further includes adhesive films 7, a light-transmitting member 8, and a back sheet 9. The adhesive films 7 are arranged on two sides of the solar cell string along the thickness direction of the solar cell string, the light-transmitting member 8 is arranged on a side of one adhesive film 7 facing away from the solar cell string, and the back sheet 9 is arranged on a side of the other adhesive film 7 facing away from the solar cell string. The solar cell string, the adhesive films 7, the light-transmitting member 8, and the back sheet 9 are stacked on one another and laminated to form a laminated structure. The photovoltaic module 10 further includes a frame (not shown in the figure), and the frame is arranged on an edge of the laminated structure. The adhesive film 7 may be made of an Ethylene-Vinyl Acetate Copolymer (EVA), Polyolefin Elastomer (POE), or Polyvinyl Butyral (PVB) and configured to package and protect the solar cell 1. For different adhesive films 7 in a same photovoltaic module 10, adhesive films 7 made of a same material or adhesive films 7 made of different materials may be selected. In some embodiments, in a same adhesive film 7, different materials are spliced together. For example, EVA adhesive films may be spliced on two sides of a POE adhesive film. In some embodiments, in a same adhesive film 7, different materials are formed by co-extrusion. For example, EVA-POE-EVA may be co-extruded to form an adhesive film or EVA-POE may be co-extruded to form an adhesive film. The light-transmitting member 8 may be a light-transmitting material member such as a glass plate, and the light-transmitting member 8 may be, for example, low-iron tempered and patterned glass. The light-transmitting member 8 has a thickness that may range from 1.6 mm to 4 mm, which has light transmittance of at least 92% for light in a spectral wavelength range of for example 380 nm to 1100 nm, and has high reflectivity for infrared light greater than 1200 nm. The back sheet 9 may be made of a light-transmitting material or an opaque material. When the back sheet 9 is made of the light-transmitting material (e.g., glass), the photovoltaic module 10 in some embodiments of the present disclosure may be a double-glass assembly, a front surface and a back surface of the photovoltaic module 10 may be used to receive solar energy, and the generated power is higher. When the back sheet 9 is made of an opaque material, the photovoltaic module 10 in some embodiments of the present disclosure may be a single-glass assembly. The back sheet 9 may be composed of a multilayer polymer film, including, for example, a polyethylene terephthalate film (PET film), an adhesive layer, and a polyvinyl fluoride film (PVF film). The PET film is used as a base layer, and two sides of the PET film are adhered to the PVF film through the adhesive layer, so that the back sheet 9 has advantages of good electrical insulation, low water vapor permeability, and high operational reliability. It is appreciated that, the back sheet 9 may be a composite of Tedlar, PET, and Tedlar (abbreviated as TPT), a thermoplastic elastomer (TPE), a composite of a fluorine film, a polyester film, and a fluorine film (abbreviated as KPK), a composite of a fluorine film, a polyester film, and EVA (abbreviated as KPE), modified polyamide (AAA), PET, PET-PET, polyphenyl ether (PPE), phenolic foam (FPF), or foamed polyethylene (FPE).

In some embodiments, referring to FIG. 2, the sidewall of the solder strip 4 abuts against a side of the second part 22 facing away from the solar cell 1. With such arrangement, compared with the related art in which the pad supports the solder strip through the fastener, in the present disclosure, a total thickness of the solder strip 4, the pad 2, and the solar cell 1 is smaller, and a total thickness of the solar cell string formed is smaller, so that a total thickness of the photovoltaic module 10 is smaller, which can save materials for assembling the frame of the photovoltaic module 10. In addition, the pad 2 is arranged on the surface of the solar cell 1, and the solder strip 4 is arranged on the side of the pad 2 facing away from the solar cell 1, so that the solar cell string is a non-flat surface assembly. When the sidewall of the solder strip 4 abuts against the side of the second part 22 facing away from the solar cell 1, compared with the related art in which the pad supports the solder strip through the fastener, in the present disclosure, the solder strip 4 has a smaller bulging extent with respect to the solar cell 1. When the adhesive film 7 is pressed and abuts against the solder strip 4, local deformation of the adhesive film 7 is less, the adhesive film 7 is difficult to be torn or damaged otherwise, and thus the service life of the adhesive film 7 is longer. Moreover, when the sidewall of the solder strip 4 abuts against the side of the second part 22 facing away from the solar cell 1, compared with the related art in which reliability of the pad supporting the solder strip through the fastener depends on structural strength of the fastener (there are many factors adversely affecting the structural strength of the fastener, such as reduction of the structural strength of the fastener due to extrusion of the fastener by the solder strip and the pad during the lamination, and reduction of the structural strength of the fastener due to poor manufacture processing of the fastener), in some embodiments of the present disclosure, the solution in which the second part 22 directly supports the solder strip 4 is less affected by the fastener 3. That is, it is more reliable that the second part 22 directly supports the solder strip 4.

Referring to FIG. 2, the fastener 3 has a set height H1, and the solder strip 4 has a set height H2, satisfying $0<H1\leq0.5*H2$. For example, $H1=0.1*H2$, $H1=0.15*H2$, $H1=0.2*H2$, $H1=0.25*H2$, $H1=0.3*H2$, $H1=0.35*H2$, $H1=0.4*H2$, $H1=0.45*H2$, or $H1=0.5*H2$ may be satisfied.

In some comparative examples, not forming part of the invention, referring to FIG. 2, when the height H1 of the fastener 3 is excessively large relative to the height H2 of the solder strip 4 ($H1>0.5*H2$), the material required for the fastener 3 is excessive, and material consumption is large. Therefore, within the range of $0<H1\leq0.5*H2$, strength of the connection between the solder strip 4 and the pad 2 can be better satisfied.

The value of H2 ranges from 0.2 mm to 0.4 mm. The value of H2 may be, for example, 0.2 mm, 0.22 mm, 0.25 mm, 0.27 mm, 0.3 mm, 0.32 mm, 0.35 mm, 0.37 mm, or 0.4 mm.

In some embodiments, referring to FIG. 3, the fastener 3 has a set width W1 along the length direction X of the solder strip 4, satisfying $0.10 \text{ mm}\leq W1\leq0.20 \text{ mm}$. The width W1 may be, for example, 0.1 mm, 0.12 mm, 0.13 mm, 0.14 mm, 0.15 mm, 0.16 mm, 0.17 mm, 0.18 mm, 0.19 mm, or 0.20 mm.

In some embodiments, referring to FIG. 3, when the width of the fastener 3 is excessively small ($W1<0.1$ mm), structural strength of the fastener 3 is lower, and it is difficult to reliably connect the solder strip 4 and the pad 2 together. When the width of the fastener 3 is excessively large ($W1>0.2$ m), the material required for the fastener 3 is excessive, and material consumption is large. Therefore, the width W1 of the fastener 3 is better in the range of 0.1 mm to 0.2 mm.

In some embodiments, referring to FIG. 2, a projection shape of the fastener 3 projected along the length direction X of the solder strip 4 is a triangle, a fan, or a slope. The fastener 3 in the above shapes has reliable structural strength, and the solder strip 4 and the pad 2 can be reliably connected together without excessively consuming the material of the fastener 3.

During the connection of the solder strip 4 and the pad 2 through the fasteners 3, there is a deformation process in the fastener 3. Therefore, after the connection is stable, the projection shape of the fastener 3 projected along the length direction X of the solder strip 4 may be approximately a triangle, a fan, or a slope. Referring to FIG. 2, when viewing from distance, a cross section of the fastener 3 is approximately in a shape of a triangle. When viewing up close, the cross section of the fastener 3 is in a shape composed of three sides, namely, a straight bottom edge connected to a side of the pad 2 facing away from the solar cell 1, a long side edge not abutting against the pad 2 or the solder strip 4, and a short side edge connected to the solder strip 4. After the solder strip 4 is connected to the pad 2 through the fastener 3 by soldering, a side of the long side edge is scaly (as shown in FIG. 3). When a cross section of the solder strip 4 is in the shape of a circle, the short side edge is in a shape of an arc that fits the sidewall of the solder strip 4. A length L3 of the straight bottom edge ranges from 0.1 mm to 0.2 mm. The length L3 may be, for example, 0.1 mm, 0.11 mm, 0.12 mm, 0.13 mm, 0.14 mm, 0.15 mm, 0.16 mm, 0.17 mm, 0.18 mm, 0.19 mm, or 0.2 mm. Referring to FIG. 3, an end of the fastener 3 facing away from the solder strip 4 is U-shaped from a top view.

In addition, the first part 21 may be provided with at least two fasteners 3 arranged apart from one another and configured to be connected to the solder strip 4. Similarly, the third part 23 may be provided with at least two fasteners 3 arranged apart from one another and configured to be connected to the solder strip 4.

In some embodiments, referring to FIG. 2, a cross section of the solder strip 4 is in a shape of a circle, and at least part of a sidewall of the solder strip 4 facing the pad 2 is connected to the pad 2 through the fastener 3. With this arrangement, a space is formed between at least part of the sidewall of the solder strip 4 facing the pad 2 and the pad 2. This space may be used to arrange at least part of the fastener 3. On the one hand, this arrangement facilitates a more compact structure, reduces the influence of the fastener 3 on the deformation of the adhesive film 7, and thus prolongs the service life of the adhesive film 7. On the other hand, the fastener 3 can reliably restrict rolling of the circular solder strip 4 relative to the pad 2. Therefore, reliability of the connection between the solder strip 4 and the pad 2 is higher.

Referring to FIG. 2, the sidewall of the circular solder strip 4 is a curved surface, which can reflect sunlight, so that part of the reflected sunlight is reflected to the surface of the solar cell 1. Moreover, the circular solder strip 4 has a smaller shielding area for the solar cell 1, so that solar energy that the solar cell 1 can receive can be increased, and generated power of the solar cell 1 per unit time is higher.

In addition, a diameter D of the circular solder strip 4 is within a range from 0.2 mm to 0.4 mm. The diameter D may be, for example, 0.2 mm, 0.22 mm, 0.25 mm, 0.27 mm, 0.3 mm, 0.32 mm, 0.35 mm, 0.37 mm, or 0.4 mm.

In some other embodiments (not shown in the figures), the cross section of the solder strip 4 may be in a shape of a rectangle, and the solder strip 4 may have a smaller height, which reduces the influence of the solder strip 4 on the deformation of the adhesive film 7 and thus prolongs the service life of the adhesive film 7. The thickness of the adhesive film 7 required may also be smaller, thereby saving the material. In some other embodiments, the cross section of the solder strip 4 is in a shape of a triangle or an ellipse. In some other embodiments, the solder strip 4 is composed of a plurality of parts with cross sections in different shapes, and at least two shapes may be selected from a circle, a rectangle, a triangle, an ellipse, or combinations thereof.

The following content is introduced mainly by taking the circular solder strip 4 as an example.

In some embodiments, referring to FIG. 4, the pad 2 has a structure in a shape of a dumbbell, a gourd, an hourglass, or a symbol "∞". The above shapes all can meet the structural requirement that the width of the second part 22 is less than the width of the first part 21 and the width of the third part 23, so as to save the material for manufacturing the pad 2 and possible of placing more fasteners 3 on the first part 21 and the third part 23 with larger widths, thereby improving the reliability of the connection between the pad 2 and the solder strip 4.

In the following content, the structure of the pad 2 is introduced mainly by taking the shape of symbol "∞" as an example.

In some embodiments, referring to FIG. 3, at least part of the first part 21 perpendicular to a sidewall of the solar cell 1 and/or at least part of the third part 23 perpendicular to the sidewall of the solar cell 1 is an arc surface. With this arrangement, the material consumption for manufacturing the pad 2 can be reduced.

Referring to FIG. 2, a thickness H3 of the pad 2 ranges from 0.01 mm to 0.03 mm. The thickness H3 may be, for example, 0.01 mm, 0.015 mm, 0.02 mm, 0.025 mm, or 0.03 mm. Heights of the first part 21, the second part 22, and the third part 23 may be the same. Alternatively, the heights of the first part 21 and the third part 23 may be the same, and the height of the first part 21 and the height of the third part 23 may be greater than the height of the second part 22, or a projection shape of the side of the pad 2 facing away from the solar cell 1 projected along the length direction X of the solder strip 4 presents a recess. Referring to FIG. 4, a shape of the first part 21 is a part of a disk, a shape of the third part 23 is also a part of the disk, and two opposite ends of the second part 22 along the length direction X of the solder strip 4 are provided with triangular notches or U-shaped notches. The radius R1 of the first part 21 and a radius R1 of the third part 23 both range from 0.1 mm to 0.2 mm. the radius R1 may be, for example, 0.1 mm, 0.11 mm, 0.12 mm, 0.13 mm, 0.14 mm, 0.15 mm, 0.16 mm, 0.17 mm, 0.18 mm, 0.19 mm, or 0.2 mm. The distance L1 between a center of the first part 21 and a center of the third part 23 ranges from 0.25 mm to 0.35 mm. The distance L1 may be, for example, 0.25 mm, 0.26 mm, 0.27 mm, 0.28 mm, 0.29 mm, 0.30 mm, 0.31 mm, 0.32 mm, 0.33 mm, 0.34 mm, or 0.35 mm. The width W2 of the second part 22 ranges from 0.05 mm to 0.15 mm. The width W2 may be, for example, 0.05 mm, 0.06 mm, 0.07 mm, 0.08 mm, 0.09 mm, 0.1 mm, 0.11 mm, 0.12 mm, 0.13 mm, 0.14 mm, or 0.15 mm. The shortest length L2 between the two opposite ends of the second part 22 along the length direction X of the solder strip 4 ranges from 0.1 mm to 0.2 mm. The length L2 may be 0.1 mm, 0.11 mm, 0.12 mm, 0.13 mm, 0.14 mm, 0.15 mm, 0.16 mm, 0.17 mm, 0.18 mm, 0.19 mm, or 0.20 mm. An angle $\alpha$ of the triangular notches at the opposite ends of the second part 22 along the length direction X of the solder strip 4 is ranging from 120° to 125°. The angle $\alpha$ may be, for example, 120°, 121°, 122°, 123°, 124°, or 125°.

In some embodiments, referring to FIG. 4, the photovoltaic module 10 further includes a finger 5 and a busbar 6 arranged on the solar cell 1, the first part 21 and the third part 23 are respectively connected to the finger 5, and the finger 5 is arranged along a direction intersecting the length direction X of the solder strip 4. The busbar 6 is connected to the second part 22, and the busbar 6 is arranged along the length direction X of the solder strip 4.

In some embodiments, referring to FIG. 4, the finger 5 is configured to collect the current of the solar cell 1, and part of the finger 5 may conduct the current to the first part 21 and the third part 23 of the pad 2. The other part of the finger 5 may be connected to the busbar 6, so as to transfer the current to the busbar 6, and the current of the busbar 6 may be conducted to the second part 22 of the pad 2. Finally, the current of the pad 2 may be conducted to the solder strip 4 through the fastener 3.

An arrangement direction of part of the finger 5 may be perpendicular to the length direction X of the solder strip 4, and an arrangement direction of the other part of the finger 5 may be inclined relative to the length direction X of the solder strip 4.

In some embodiments, referring to FIG. 4, the fastener 3 is made of tin, solder paste, conductive silver paste, or a conductive adhesive. The above materials are all conductive materials and can better satisfy conductivity and connection properties.

The tin is pure tin metal. The solder paste is a paste mixture including solder powder, flux, a surfactant, and a thixotropic agent. The conductive silver paste is polymer silver conductive paste (dried or cured to form a film, with an organic polymer as a bonding phase). The conductive adhesive is an adhesive with certain conductivity after cured or dried.

In addition, when the fastener 3 is made of the tin, solder paste, or conductive silver paste, the solder strip 4 is soldered to the pad 2 through the fastener 3 by soldering. When the fastener 3 is made of the conductive adhesive, the solder strip 4 is cured and adhered to the pad 2 through the fastener 3 by dispensing. In one or more possible embodiments, the solder strip 4 is cured and adhered to the pad 2 through the fastener 3 by soldering and dispensing. The reliability of the connection is higher in such embodiments.

In some embodiments, the pad 2 may be made of sintered silver conductive paste (sintered to form a film at a sintering temperature greater than 500°C and with glass powder or oxide as a bonding phase).

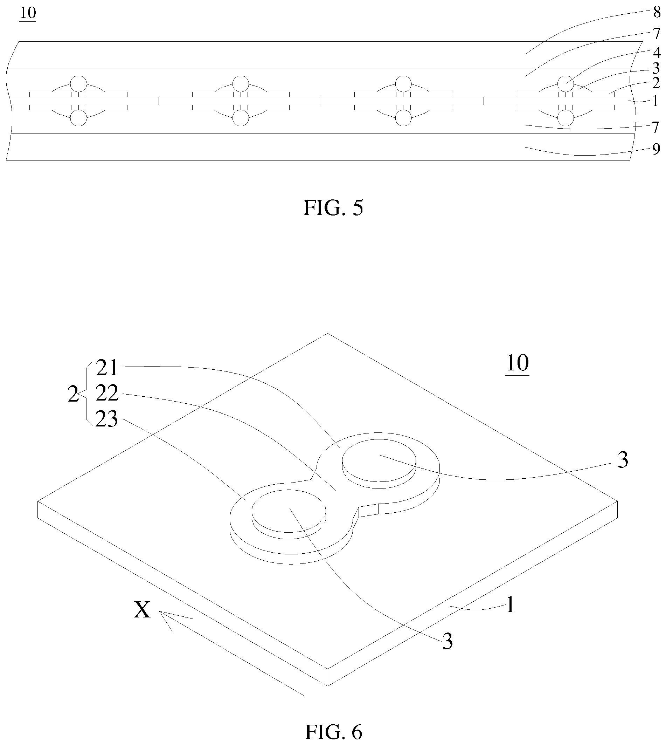

In some other embodiments, referring to FIG. 5, two sides of the solar cell 1 each may be provided with the pad 2. The pads 2 on the two sides of the solar cell 1 may be connected to the corresponding solder strips 4 through the corresponding fasteners 3.

The solar cell 1 of the photovoltaic module 10 in the above embodiments may be an Interdigitated Back Contact (IBC) solar cell, a Passivated Emitter Rear Cell (PERC) solar cell, or a Tunnel Oxide Passivated Contact (TOPcon) solar cell.

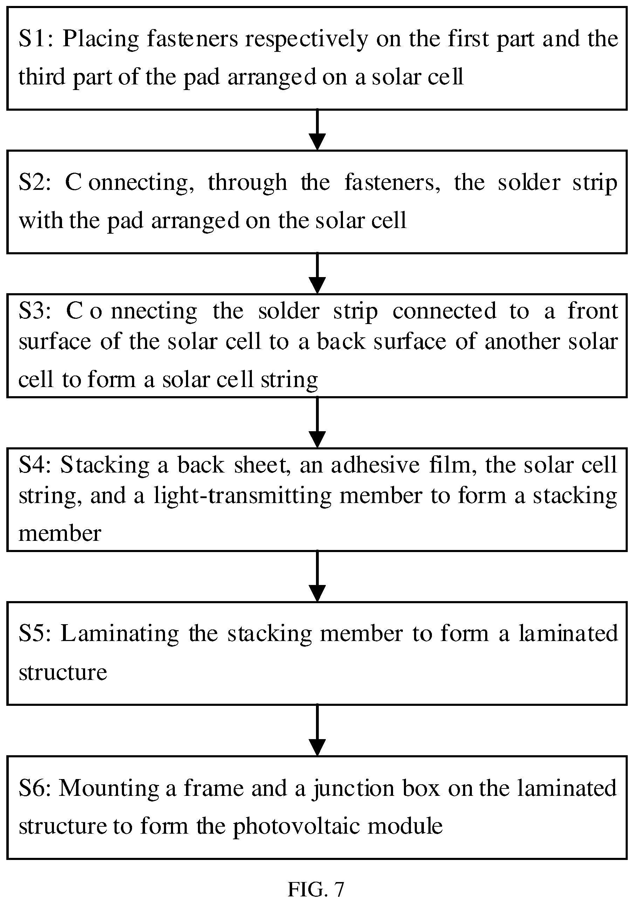

In a second aspect, some embodiments of the present disclosure provide a method for manufacturing photovoltaic module. Referring to FIG. 6, the pad 2 of the photovoltaic module 10 has a first part 21, a second part 22, and a third part 23, the first part 21 is connected to the third part 23 through the second part 22, and along a length direction X of the solder strip 4 of the photovoltaic module 10, a width of the second part 22 is less than a width of the first part 21 and a width of the third part 23. Referring to FIG. 7, the method includes:

> S1: placing fasteners 3 respectively on the first part 21 and the third part 23 of the pad 2 arranged on a solar cell 1;
> S2: connecting, through the fasteners 3, the solder strip 4 with the pad 2 arranged on the solar cell 1;
> S3: connecting the solder strip 4 connected to a front surface of the solar cell 1 to a back surface of another solar cell 1 to form a solar cell string;
> S4: stacking a back sheet 9, an adhesive film 7, the solar cell string, and a light-transmitting member 8 to form a stacking member;
> S5: laminating the stacking member to form a laminated structure; and
> S6: mounting a frame (not shown in the figure) and a junction box (not shown in the figure) on the laminated structure to form the photovoltaic module 10.

In some embodiments, referring to FIG. 7, in step S1, the fasteners 3 are placed on the first part 21 and the third part 23 of the pad 2 arranged on the solar cell 1 to form the structure as shown in FIG. 6. In step S2, the solder strip 4 is connected, through the fasteners 3, to the pad 2 arranged on the solar cell 1 to form the structure as shown in FIG. 3. Compared with the method for manufacturing photovoltaic module in the related art, in the method according to some embodiments of the present disclosure, there are more fixed connection positions between the solder strip 4 and the pad 2, and the connection between the solder strip 4 and the pad 2 has higher reliability. As a result, the photovoltaic module 10 has higher operational reliability and a longer service life. In step S3, the solder strip 4 connected to the front surface of the solar cell 1 is connected to the back surface of another solar cell 1 to form a solar cell string, so as to implement the following process: the solar cell 1 uses a semiconductor photoelectric effect to generate electric energy after receiving solar energy, and the electric energy of the solar cell 1 may be conducted sequentially through the pad 2 electrically connected to the solar cell 1, the fastener 3 electrically connected to the pad 2, and the solder strip 4 electrically connected to the fastener 3. In step S4, the back sheet 9, the adhesive film 7, the solar cell string, and the light-transmitting member 8 are stacked by using a stacking machine, to form the stacking member. Two sides of the solar cell string are each provided with the adhesive film 7, the light-transmitting member 8 are arranged on a side of one adhesive film 7 facing away from the solar cell string, and the back sheet 9 is arranged on a side of the other adhesive film 7 facing away from the solar cell string. In step S5, the stacking member is laminated by using a laminator, to form the laminated structure. In step S6, the frame (not shown in the figure) and the junction box (not shown in the figure) are mounted on the laminated structure to form the photovoltaic module 10, the frame is configured to protect edges of the laminated structure, and the junction box is configured to receive the current of the solar cell string.

The solar cell 1 in step S1 is an entire solar cell, and the fasteners 3 are placed on the pad 2 arranged on the entire solar cell. Between step S1 and step S2, the entire solar cell is sliced into a natural number of cuts greater than two such as two cuts, three cuts, or four cuts. Compared with the method in the related art in which there is a need to mount, position, place the fastener 3 on, and disassemble each solar cell cut, in the method according to the present disclosure, the entire solar cell is required only to be mounted, positioned, and disassembled once. The method of the present disclosure can save a lot of manufacturing time and has higher production efficiency. After the entire solar cell is sliced into solar cell cuts, the solar cell cuts may be sorted in terms of electrical properties to manufacture the photovoltaic module 10 with different property parameters. Between step S5 and step S6, edges of the laminated structure may be trimmed to cut an exposed part of the adhesive film 7 from the laminated structure. Subsequent to step S6, silica gel (not shown in the figure) located on the frame of the photovoltaic module 10 is cured, the photovoltaic module 10 is cleaned, and structural properties and electrical properties of the photovoltaic module 10 are detected.

In some embodiments, step S2 of connecting, through the fasteners 3, the solder strip 4 with the pad 2 arranged on the solar cell 1 includes: abutting the solder strip 4 against a side of the second part 22 facing away from the solar cell 1, and placing the solder strip 4 between the fastener 3 on a side of the first part 21 facing away from the solar cell 1 and the fastener 3 on a side of the third part 23 facing away from the solar cell 1. Compared with the related art in which the pad supports the solder strip through the fastener, in the method according to some embodiments of the present disclosure, in the manner of abutting the solder strip 4 against the side of the second part 22 facing away from the solar cell 1, the total thickness of the solder strip 4, the pad 2, and the solar cell 1 is smaller, and the total thickness of the solar cell string formed is smaller, so that the total thickness of the photovoltaic module 10 is smaller, which can save materials for assembling the frame of the photovoltaic module 10. In addition, the pad 2 is arranged on the surface of the solar cell 1, and the solder strip 4 is arranged on the side of the pad 2 facing away from the solar cell 1, so that the solar cell string is a non-flat surface assembly. When the sidewall of the solder strip 4 abuts against the side of the second part 22 facing away from the solar cell 1, compared with the related art in which the pad supports the solder strip through the fastener, in the method according to some embodiments of the present disclosure, the solder strip 4 has a smaller bulging height with respect to the solar cell 1. When the adhesive film 7 is pressed and abuts against the solder strip 4, local deformation of the adhesive film 7 is less, the adhesive film 7 is difficult to be torn, or damaged otherwise, and thus the service life of the adhesive film 7 is longer. Moreover, when the sidewall of the solder strip 4 abuts against the side of the second part 22 facing away from the solar cell 1, compared with the related art in which reliability of the pad supporting the solder strip through the fastener depends on structural strength of the fastener (there are many factors adversely affecting the structural strength of the fastener, such as reduction of the structural strength of the fastener due to extrusion of the fastener by the solder strip and the pad during the lamination, and reduction of the structural strength of the fastener due to poor manufacture processing of the fastener), in the method according to some embodiments of the present disclosure, the solution in which the second part 22 directly supports the solder strip 4 is less affected by the fastener 3. That is, it is more reliable that the second part 22 directly supports the solder strip 4. In the method according to some embodiments of the present disclosure, a position where the solder strip 4 is fixedly connected to the first part 21 and a position where the solder strip 4 is fixedly connected to the third part 23 are symmetrical with respect to the length direction X of the solder strip 4, which further improves stability of the connection structure between the solder strip 4 and the pad 2.

The above are merely preferred embodiments of the present disclosure and are not intended to limit the present disclosure. The scope of the present disclosure is defined by the appended claims.

**Claims**

1. A photovoltaic module (10), comprising:

    at least one solar cell (1);
    a solder strip (4);
    a pad (2) arranged on a surface of the solar cell and including a first part (21), a second part (22), and a third part (23), wherein the first part is connected to the third part through the second part, and along a length direction (X) of the solder strip (4), a width of the second part is less than a width of the first part and a width of the third part;
    fasteners (3) arranged on a side of the first part (21) facing away from the solar cell and a side of the third part (23) facing away from the solar cell, wherein the solder strip (4) is provided between the fastener in the first part and the fastener in the third part, and the solder strip is connected to the pad (2) through the fasteners to form a solar cell string;
    adhesive films (7) arranged on two sides of the solar cell string along a thickness direction of the solar cell string;
    a light-transmitting member (8) arranged on a side of one of the adhesive films facing away from the solar cell string; and
    a back sheet (9) arranged on a side of the other one of the adhesive films facing away from the solar cell string,
    wherein each fastener (3) has a set height H1, and the solder strip (4) has a set height H2, where

$$0 < H1 \leq 0.5*H2.$$

2. The photovoltaic module according to claim 1, wherein a sidewall of the solder strip abuts against a side of the second part (22) facing away from the solar cell.

3. The photovoltaic module according to claim 1, wherein each fastener (3) has a set width W1 along the length direction of the solder strip, where $0.10 \text{ mm} \leq W1 \leq 0.20 \text{ mm}$.

4. The photovoltaic module according to claim 1, wherein a projection of each fastener projected along the length direction of the solder strip (4) is in a shape of a triangle, a fan, or a slope.

**5.** The photovoltaic module according to claim 4, wherein when the projection of each fastener (3) is in a shape of a triangle, the triangle includes a flat bottom edge connected to a side of the pad (2) facing away from the solar cell, a long side edge not abutting against with the pad or the solder strip, and a short side edge connected to the solder strip.

**6.** The photovoltaic module according to claim 5, wherein the bottom edge of the triangle has a length L3 in a range of 0.1 mm to 0.2 mm.

**7.** The photovoltaic module according to claim 5, wherein the long side edge has a scaly surface, and the short side edge has an arc shape fitting with a contour of a sidewall of the solder strip.

**8.** The photovoltaic module according to claim 1, wherein a cross section of the solder strip (4) is in a shape of a circle, and at least part of a sidewall of the solder strip facing the pad (2) is connected to the pad through each fastener (3); or a cross section of the solder strip is in a shape of a triangle, a rectangle, or an ellipse.

**9.** The photovoltaic module according to claim 1, wherein the pad has a shape of a dumbbell, a gourd, an hourglass, or a symbol ∞.

**10.** The photovoltaic module according to claim 1, wherein at least part of the first part (21) perpendicular to a sidewall of the solar cell and/or at least part of the third part (23) perpendicular to the sidewall of the solar cell is an arc surface.

**11.** The photovoltaic module according to claim 1, further comprising a finger (5) and a busbar (6) arranged on the solar cell, the first part (21) and the third part (23) are respectively connected to the finger,

and the finger is arranged along a direction intersecting with the length direction of the solder strip; and
the busbar is connected to the second part, and the busbar is arranged along the length direction of the solder strip.

**12.** The photovoltaic module according to any one of claims 1 to 11, wherein each fastener (3) is made of tin, solder paste, conductive silver paste, or conductive adhesive.

**13.** A method for manufacturing a photovoltaic module, wherein the photovoltaic module (10) includes at least one solar cell (1), a solder strip (4), a pad (2), fasteners (3), adhesive films (7), a light-transmitting member (8), and a back sheet (9), the pad includes a first part (21), a second part (22), and a third part (23), the first part is connected to the third part through the second part, and along a length direction of the solder strip, a width of the second part is less than a width of the first part and a width of the third part, wherein the method comprises:

placing the fasteners respectively on the first part and the third part of the pad arranged on the solar cell;
connecting, through the fasteners, the solder strip with the pad arranged on the solar cell;
connecting the solder strip connected to a front surface of the solar cell to a back surface of another solar cell to form a solar cell string;
stacking the back sheet, the adhesive film, the solar cell string, and the light-transmitting member to form a stacking member;
laminating the stacking member to form a laminated structure; and
mounting a frame and a junction box on the laminated structure to form the photovoltaic module,
wherein each fastener has a set height H1, and the solder strip has a set height H2, where

$$0 < H1 \leq 0.5 * H2.$$

**14.** The method for manufacturing a photovoltaic module according to claim 13, wherein
the connecting, through the fasteners, the solder strip with the pad arranged on the solar cell comprises:
abutting the solder strip against a side of the second part facing away from the solar cell, and placing the solder strip between the fastener on a side of the first part facing away from the solar cell and the fastener on a side of the third part facing away from the solar cell.

**Patentansprüche**

**1.** Photovoltaikmodul (10), umfassend:

mindestens eine Solarzelle (1);
einen Lotstreifen (4);
ein Pad (2), das auf einer Oberfläche der Solarzelle angeordnet ist und einen ersten Teil (21), einen zweiten Teil (22) und einen dritten Teil (23) beinhaltet,
wobei der erste Teil durch den zweiten Teil mit dem dritten Teil verbunden ist und entlang einer Längsrichtung (X) des Lotstreifens (4) eine Breite des zweiten Teils kleiner als eine Breite des ersten Teils und eine Breite des dritten Teils ist;
Befestigungselemente (3), die auf einer von der Solarzelle abgewandten Seite des ersten Teils (21) und einer von der Solarzelle abgewandten Seite des dritten Teils (23) angeordnet sind, wobei der Lotstreifen (4) zwischen dem Befestigungselement in dem ersten Teil und dem Befestigungselement in dem dritten Teil bereitgestellt ist und der Lotstreifen durch die Befestigungselemente mit dem Pad (2) verbunden ist, um einen Solarzellenstring zu bilden;
Klebefolien (7), die auf zwei Seiten des Solarzellenstrings entlang einer Dickenrichtung des Solarzellenstrings angeordnet sind;
ein lichtdurchlässiges Element (8), das auf einer Seite einer der Klebefolien angeordnet ist, die von dem Solarzellenstring abgewandt ist; und
eine Rücklage (9), die auf einer Seite der anderen der Klebefolien angeordnet ist, die von dem Solarzellenstring abgewandt ist,
wobei jedes Befestigungselement (3) eine festgelegte Höhe H1 aufweist und der Lotstreifen (4) eine festgelegte Höhe H2 aufweist, wobei 0<H1≤0,5*H2.

2. Photovoltaikmodul nach Anspruch 1, wobei eine Seitenwand des Lotstreifens an einer von der Solarzelle abgewandten Seite des zweiten Teils (22) anliegt.

3. Photovoltaikmodul nach Anspruch 1, wobei jedes Befestigungselement (3) eine festgelegte Breite W1 entlang der Längsrichtung des Lotstreifens aufweist, wobei 0,10 mm≤W1≤0,20 mm.

4. Photovoltaikmodul nach Anspruch 1, wobei ein Vorsprung jedes Befestigungselements, der entlang der Längsrichtung des Lotstreifens (4) vorsteht, in einer Form eines Dreiecks, eines Lüfters oder einer Schräge ist.

5. Photovoltaikmodul nach Anspruch 4, wobei, wenn der Vorsprung jedes Befestigungselements (3) in einer Form eines Dreiecks ist, das Dreieck eine flache untere Kante, die mit einer Seite des Pads (2) verbunden ist, die von der Solarzelle abgewandt ist, eine lange Seitenkante, die nicht an dem Pad oder dem Lotstreifen anliegt, und eine kurze Seitenkante, die mit dem Lotstreifen verbunden ist, beinhaltet.

6. Photovoltaikmodul nach Anspruch 5, wobei die untere Kante des Dreiecks eine Länge L3 in einem Bereich von 0,1 mm bis 0,2 mm aufweist.

7. Photovoltaikmodul nach Anspruch 5, wobei die lange Seitenkante eine schuppige Oberfläche aufweist und die kurze Seitenkante eine Bogenform aufweist, die zu einer Kontur einer Seitenwand des Lotstreifens passt.

8. Photovoltaikmodul nach Anspruch 1, wobei ein Querschnitt des Lotstreifens (4) kreisförmig ist und mindestens ein Teil einer Seitenwand des Lotstreifens, die dem Pad (2) zugewandt ist, durch jedes Befestigungselement (3) mit dem Pad verbunden ist; oder
ein Querschnitt des Lotstreifens eine Form eines Dreiecks, eines Rechtecks oder einer Ellipse aufweist.

9. Photovoltaikmodul nach Anspruch 1, wobei das Pad eine Form einer Hantel, eines Kürbisses, einer Sanduhr oder eines Symbols ∞ aufweist.

10. Photovoltaikmodul nach Anspruch 1, wobei mindestens ein Teil des ersten Teils (21) senkrecht zu einer Seitenwand der Solarzelle und/oder mindestens ein Teil des dritten Teils (23) senkrecht zu der Seitenwand der Solarzelle eine Bogenfläche ist.

11. Photovoltaikmodul nach Anspruch 1, ferner umfassend einen Finger (5) und eine an der Solarzelle angeordnete Stromschiene (6), wobei der erste Teil (21) und der dritte Teil (23) jeweils mit dem Finger verbunden sind,

und der Finger entlang einer Richtung angeordnet ist, die sich mit der Längsrichtung des Lotstreifens schneidet; und
die Stromschiene mit dem zweiten Teil verbunden ist und die Stromschiene entlang der Längsrichtung des Lotstreifens angeordnet ist.

12. Photovoltaikmodul nach einem der Ansprüche 1 bis 11, wobei jedes Befestigungselement (3) aus Zinn, Lötpaste, leitfähiger Silberpaste oder leitfähigem Klebstoff gefertigt ist.

13. Verfahren zur Herstellung eines Photovoltaikmoduls, wobei das Photovoltaikmodul (10) mindestens eine Solarzelle (1), einen Lotstreifen (4), ein Pad (2), Befestigungselemente (3), Klebefolien (7), ein lichtdurchlässiges Element (S) und eine Rücklage (9) umfasst,

das Pad einen ersten Teil (21), einen zweiten Teil (22) und einen dritten Teil (23) beinhaltet, der erste Teil durch den zweiten Teil mit dem dritten Teil verbunden ist und entlang einer Längsrichtung des Lotstreifens eine Breite des zweiten Teils kleiner als eine Breite des ersten Teils und eine Breite des dritten Teils ist, wobei das Verfahren Folgendes umfasst:

Platzieren der Befestigungselemente jeweils auf dem ersten Teil und dem dritten Teil des Pads, das auf der Solarzelle angeordnet ist;

Verbinden des Lotstreifens mit dem auf der Solarzelle angeordneten Pad durch die Befestigungselemente;

Verbinden des Lotstreifens, der mit einer Vorderfläche der Solarzelle verbunden ist, mit einer Rückfläche einer anderen Solarzelle, um einen Solarzellenstring zu bilden;

Stapeln der Rücklage, der Klebefolie, des Solarzellenstrings und des lichtdurchlässigen Elements, um ein Stapelelement zu bilden;

Laminieren des Stapelelements, um eine laminierte Struktur zu bilden; und

Montieren eines Rahmens und eines Anschlusskastens an der laminierten Struktur, um das Photovoltaikmodul zu bilden,

wobei jedes Befestigungselement eine festgelegte Höhe H1 aufweist und der Lotstreifen eine festgelegte Höhe H2 aufweist, wobei $0 < H1 \leq 0,5*H2$.

14. Verfahren zur Herstellung eines Photovoltaikmoduls nach Anspruch 13, wobei das Verbinden des Lotstreifens mit dem auf der Solarzelle angeordneten Pad durch die Befestigungselemente Folgendes umfasst:

Anlegen des Lotstreifens an eine Seite des zweiten Teils, die von der Solarzelle abgewandt ist, und Platzieren des Lotstreifens zwischen dem Befestigungselement auf einer Seite des ersten Teils, die von der Solarzelle abgewandt ist, und dem Befestigungselement auf einer Seite des dritten Teils, die von der Solarzelle abgewandt ist.

## Revendications

1. Module photovoltaïque (10) comprenant :

au moins une cellule solaire (1) ;
une bande de soudure (4) ;
une pastille (2) disposée sur une surface de la cellule solaire et comprenant une première partie (21), une deuxième partie (22) et une troisième partie (23),

dans lequel la première partie est reliée à la troisième partie par l'intermédiaire de la deuxième partie, et le long d'une direction de longueur (X) de la bande de soudure (4), une largeur de la deuxième partie est inférieure à une largeur de la première partie et à une largeur de la troisième partie ;

des éléments de fixation (3) disposés sur une face de la première partie (21) opposée à la cellule solaire et sur une face de la troisième partie (23) opposée à la cellule solaire, la bande de soudure (4) étant placée entre l'élément de fixation de la première partie et l'élément de fixation de la troisième partie, et la bande de soudure étant reliée à la pastille (2) par l'intermédiaire des éléments de fixation pour former une chaîne de cellules solaires ;

des films adhésifs (7) disposés sur les deux côtés de la chaîne de cellules solaires le long d'une direction d'épaisseur de la chaîne de cellules solaires ;

un élément transmetteur de lumière (8) disposé sur une face de l'un des films adhésifs opposée à la chaîne de cellules solaires ; et

une feuille arrière (9) disposée sur une face de l'autre des films adhésifs opposée à la chaîne de cellules solaires,

dans lequel chaque élément de fixation (3) a une hauteur définie H1, et la bande de soudure (4) a une hauteur définie H2, où $0 < H1 \leq 0,5*H2$.

2. Module photovoltaïque selon la revendication 1, dans lequel une paroi latérale de la bande de soudure vient en butée contre une face de la deuxième partie (22) opposée à la cellule solaire.

3. Module photovoltaïque selon la revendication 1, dans lequel chaque élément de fixation (3) a une largeur définie W1 le long de la direction de la longueur de la bande de soudure, où $0,10 \text{ mm} \leq W1 \leq 0,20 \text{ mm}$.

4. Module photovoltaïque selon la revendication 1, dans lequel une projection de chaque élément de fixation projeté le long de la direction de la longueur de la bande de soudure (4) a la forme d'un triangle, d'un éventail ou d'une pente.

5. Module photovoltaïque selon la revendication 4, dans lequel lorsque la projection de chaque élément de fixation (3) est en forme de triangle, le triangle comprend un bord inférieur plat relié à une face de la pastille (2) opposée à la cellule solaire, un bord latéral long qui n'est pas en contact avec la pastille ou la bande de soudure, et un bord latéral court relié à la bande de soudure.

6. Module photovoltaïque selon la revendication 5, dans lequel le bord inférieur du triangle a une longueur L3 comprise entre 0,1 mm et 0,2 mm.

7. Module photovoltaïque selon la revendication 5, dans lequel le bord latéral long a une surface écailleuse, et le bord latéral court a une forme d'arc s'adaptant au contour d'une paroi latérale de la bande de soudure.

8. Module photovoltaïque selon la revendication 1, dans lequel une section transversale de la bande de soudure (4) est en forme de cercle, et au moins une partie d'une paroi latérale de la bande de soudure faisant face à la pastille (2) est reliée à la pastille par chaque élément de fixation (3) ; ou une section transversale de la bande de soudure a la forme d'un triangle, d'un rectangle ou d'une ellipse.

9. Module photovoltaïque selon la revendication 1, dans lequel la pastille a la forme d'un haltère, d'une gourde, d'un sablier ou du symbole ∞.

10. Module photovoltaïque selon la revendication 1, dans lequel au moins une partie de la première partie (21) perpendiculaire à une paroi latérale de la cellule solaire et/ou au moins une partie de la troisième partie (23) perpendiculaire à la paroi latérale de la cellule solaire est une surface en arc.

11. Module photovoltaïque selon la revendication 1, comprenant en outre un doigt (5) et une barre omnibus (6) disposés sur la cellule solaire, la première partie (21) et la troisième partie (23) étant respectivement reliées au doigt,

et le doigt est disposé le long d'une direction coupant la direction de la longueur de la bande de soudure ; et la barre omnibus est reliée à la deuxième partie, et la barre omnibus est disposée dans le sens de la longueur de la bande de soudure.

12. Module photovoltaïque selon l'une quelconque des revendications 1 à 11, dans lequel chaque élément de fixation (3) est fait d'étain, de pâte à souder, de pâte d'argent conductrice ou d'adhésif conducteur.

13. Procédé de fabrication d'un module photovoltaïque, dans lequel le module photovoltaïque (10) comprend au moins une cellule solaire (1), une bande de soudure (4), une pastille (2), des éléments de fixation (3), des films adhésifs (7), un élément transmettant la lumière (S) et une feuille arrière (9),

la pastille comprend une première partie (21), une deuxième partie (22) et une troisième partie (23), la première partie est reliée à la troisième partie à travers la deuxième partie, et le long d'une direction de longueur de la bande de soudure, une largeur de la deuxième partie est inférieure à une largeur de la première partie et à une largeur de la troisième partie, dans lequel le procédé comprend :

le placement des éléments de fixation respectivement sur la première partie et la troisième partie de la pastille disposée sur la cellule solaire ; la liaison, par l'intermédiaire des éléments de fixation, de la bande de soudure à la pastille disposée sur la cellule solaire ; la liaison de la bande de soudure reliée à la surface avant de la cellule solaire à la surface arrière d'une autre cellule solaire pour former une chaîne de cellules solaires ; l'empilage de la feuille arrière, le film adhésif, la chaîne de cellules solaires et l'élément transmetteur de lumière pour former un élément d'empilage ; la stratification de l'élément d'empilage pour former une structure stratifiée ; et le montage d'un cadre et d'une boîte de jonction sur la structure stratifiée pour former le module photovoltaïque, dans lequel chaque élément de fixation a une hauteur définie H1, et la bande de soudure a une hauteur définie H2, où $0 < H1 \leq 0,5 * H2$.

14. Procédé de fabrication d'un module photovoltaïque selon la revendication 13, dans lequel la liaison, par l'intermédiaire des éléments de fixation, de la bande de soudure avec la pastille disposée sur la cellule solaire comprend : l'application de la bande de soudure contre une face de la deuxième partie opposée à la cellule solaire, et le placement de la bande de soudure entre l'élément de fixation sur une face de la première partie opposée à la cellule solaire et l'élément de fixation sur une face de la troisième partie opposée à la cellule solaire.

FIG. 1

FIG. 2

FIG. 3

FIG. 4

FIG. 5

FIG. 6

S1: Placing fasteners respectively on the first part and the third part of the pad arranged on a solar cell

↓

S2: Connecting, through the fasteners, the solder strip with the pad arranged on the solar cell

↓

S3: Connecting the solder strip connected to a front surface of the solar cell to a back surface of another solar cell to form a solar cell string

↓

S4: Stacking a back sheet, an adhesive film, the solar cell string, and a light-transmitting member to form a stacking member

↓

S5: Laminating the stacking member to form a laminated structure

↓

S6: Mounting a frame and a junction box on the laminated structure to form the photovoltaic module

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 110611007 A